Europäisches Patentamt

European Patent Office

Office européen des brevets

(19)

(11) Numéro de publication : **0 550 347 A1**

(12) # DEMANDE DE BREVET EUROPEEN

(21) Numéro de dépôt : **92403587.6**

(22) Date de dépôt : **30.12.92**

(51) Int. Cl.⁵ : **G11C 15/00**

(30) Priorité : **03.01.92 FR 9200024**

(43) Date de publication de la demande :
**07.07.93 Bulletin 93/27**

(84) Etats contractants désignés :
**DE GB**

(71) Demandeur : **FRANCE TELECOM**
**Etablissement autonome de droit public, 6,**
**Place d'Alleray**
**F-75015 Paris (FR)**

(72) Inventeur : **Ali-Yahia, Tahar**
**2, Sente de la Marquette**
**F-78220 Viroflay (FR)**
Inventeur : **Dana, Michel**
**53, rue de la Colonie**
**F-75013 Paris (FR)**

(74) Mandataire : **Mongrédien, André et al**
**c/o BREVATOME 25, rue de Ponthieu**
**F-75008 Paris (FR)**

(54) **Point mémoire pour mémoire associative.**

(57)     L'invention concerne un point mémoire pour mémoire associative statique comprenant deux ensembles de transistors, un premier ensemble ayant une fonction de mémorisation des données et un deuxième ensemble ayant une fonction de comparaison entre la donnée mémorisée et une donnée que l'on applique à l'entrée du point, le résultat de comparai son étant obtenu sur une ligne de sélection S, dans lequel le deuxième ensemble T1, T2, T3, T4) de transistors est formé en partie par des transistors du premier ensemble (T3, T4, T7, T8, T5, T6), la structure du point ayant ainsi un encombrement réduit par rapport aux structures connues.

Application aux mémoires associatives.

FIG. 2

FIG. 3

L'invention concerne un point mémoire pour mémoire associative et une mémoire associative comportant un plan mémoire constitué d'un ensemble de ces points.

Pour toute application nécessitant un traitement associatif, les solutions actuelles font appel à l'utilisation de mémoires associatives comportant un plan mémoire constitué d'un ensemble de points mémoire statiques CMOS. Chaque point est constitué de six transistors pour mémoriser l'information et d'une logique de comparaison comprenant quatre transistors. Cette solution a été utilisée dans des mémoires associatives pour les calculateurs "Data Flow" (Matsushita Electrical Industrial, Japan) dont on pourra trouver une description dans l'article de Hiroshi Kadota and al, intitulé "An 8-Kbit Content-Adressable and Reentrant Memory", paru dans IEEE Journal of Solid-State Circuits, volume SC-20, No 5, octobre 1988, pages 543-547.

Cette solution a également été utilisée pour les réseaux locaux (AMD, Am99C10) dont on pourra trouver l'annonce du circuit dans l'article intitulé "Donnez-lui le mot de passe, la mémoire se chargera de trouver l'information" d'Electronique Hebdo, N° 97, page 19, 1989.

Pour augmenter la capacité de stockage des mémoires associatives et répondre à des opérations ou à des contraintes spécifiques à certaines applications que les cellules mémoire statiques ne peuvent satisfaire, plusieurs solutions de cellules mémoire ont été proposées. Parmi ces contraintes spécifiques, on notera par exemple le cas de l'écriture simultanée sur plusieurs mots de la mémoire.

Comme solution, on peut citer les cellules mémoire pseudo-statiques à huit transistors, utilisées dans une mémoire associative dédiée au traitement du signal et d'images. On pourra en trouver une description détaillée dans l'article de Simon R. Jones et al, intitulé "A 9 Kbit Associative Memory for High-Speed Parallel Processing Applications", paru dans l'IEEE Journal of Solid-State Circuits, volume 23, N° 2, avril 1988, pages 543-547.

On peut citer également les cellules mémoire à sept transistors NMOS plus deux éléments résistifs de charge en poly-Si qui sont utilisés dans une mémoire associative pour les applications d'intelligence artificielle, dont on pourra trouver une description détaillée dans l'article de Takeshi Ogura et al, intitulé "A 20 Kb CMOS Associative Memory Lsi for Artificial Intelligence Applications", paru dans Proceedings of the IEEE int. lors de la conférence Computer Design (ICCD 86), pages 574-577.

On peut aussi citer les cellules mémoire dynamiques à cinq transistors, utilisées dans une mémoire associative pour accélérer les opérations de recherche dans les bases de données. On pourra en trouver une description détaillée dans l'article de J.P. Wade et Ch. G. Sodini, intitulé "Dynamic Cross-Coupled Bit-Line Content Addressable Memory Cell for High-Density Array", paru dans IEEE Journal of Solid-State Circuits, volume SC-22, N° 1, février 1987, pages 119-121.

Or la réalisation de mémoires associatives utilisant des solutions basées sur des plans mémoire constitués de points mémoire associatifs statiques à dix transistors en technologie CMOS tels que décrits précédemment, conduit à de faibles capacités de stockage. Cela implique que pour résoudre un problème de recherche associative nécessitant une capacité de stockage importante, il faut un plus grand nombre de processeurs de mémoires associatives, ces solutions devenant alors des solutions très coûteuses.

Les solutions basées sur des points mémoire associatifs dynamiques à cinq transistors en technologie NMOS, améliorent sensiblement la capacité de stockage, mais sont moins rapides étant donné qu'il y a nécessité d'une étape de rafraîchissement des points mémoire après chaque opération, d'où une source de consommation supplémentaire.

La présente invention permet de résoudre ce problème. Elle a pour objet un point mémoire de haute densité et une mémoire associative comprenant un plan mémoire constitué de tels points mémoire et dont le degré d'intégration et la capacité sont ainsi accrûs.

L'utilisation de tels points mémoire permet d'une part de mettre en oeuvre sur un seul circuit une capacité de stockage équivalente à 512 Kbit pour des applications ne nécessitant pas une gestion de réponses multiples (mémoires caches par exemple) et d'autre part, d'augmenter les domaines d'utilisation d'une mémoire associative, en utilisant le gain en surface obtenu pour intégrer des unités de traitement supplémentaires.

Ainsi la présente invention permet de réaliser des mémoires associatives de large capacité, ainsi que d'élargir leurs domaines d'application du fait que l'on peut obtenir un gain de place pour une capacité de stockage donnée, ce qui permet de rajouter des opérateurs sur le circuit intégré.

La présente invention a plus particulièrement pour objet un point mémoire pour mémoire associative statique comprenant deux ensembles de transistors, un premier ensemble ayant une fonction de mémorisation des données et un deuxième ensemble ayant une fonction de comparaison entre la donnée mémorisée et une donnée que l'on applique à l'entrée du point, le résultat de comparaison étant obtenu sur une ligne de sélection S, le deuxième ensemble de transistors étant formé en partie par des transistors du premier ensemble.

Selon un premier mode de réalisation, le premier ensemble comporte d'une part quatre transistors pour la mémorisation et d'autre part, deux transistors d'accès reliés à deux lignes de bits et à une ligne de mots, le deuxième ensemble comportant deux transistors, les deux transistors de décharge du point étant associés à ces deux transistors du deuxième ensemble pour assurer la fonction comparaison, la donnée à comparer étant appliquée aux lignes de bits reliées aux deux transistors d'accès du point et la ligne de sélection S étant préchargée lors des lectures-écritures et lors des comparaisons.

Selon un deuxième mode de réalisation le premier ensemble comporte d'une part quatre transistors pour la mémorisation et d'autre part, deux transistors d'accès reliés à deux lignes de bits et à une ligne de mots, le deuxième ensemble comportant deux transistors, les deux transistors N assurant la décharge du point étant associés aux deux transistors du deuxième ensemble pour assurer la fonction comparaison, la donnée à comparer étant appliquée à deux autres lignes de bits (COMP, $\overline{COMP}$) reliées aux deux transistors du deuxième ensemble.

Conformément à un autre aspect de l'invention, les points mémoire sont réalisés en technologie CMOS.

La présente invention a également pour objet une mémoire associative statique comprenant un plan mémoire constitué d'une matrice de points mémoire.

La présente invention sera mieux comprise à l'aide de la description qui va suivre, faite à titre indicatif et nullement limitatif et à partir des dessins annexés sur lesquels :
- la figure 1 représente un schéma d'un point mémoire statique à dix transistors selon l'art antérieur,
- la figure 2 représente un schéma d'un point mémoire statique conforme à l'invention selon un premier mode de réalisation,
- la figure 3 représente le schéma d'un point mémoire statique conforme à l'invention selon un deuxième mode de réalisation.

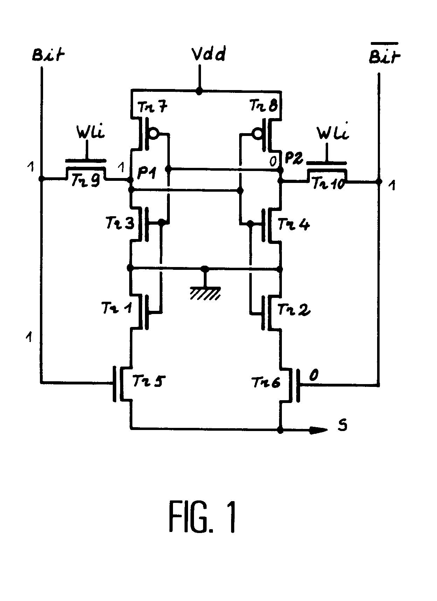

On va rappeler dans ce qui suit le fonctionnement d'un point mémoire statique à dix transistors conforme à l'état de la technique, ce point mémoire a été représenté sur le schéma de la figure 1.

Dans une mémoire associative statique, chaque point mémoire du plan mémoire comporte un pemier ensemble de transistors assurant une fonction de mémorisation et un deuxième ensemble assurant une fonction de comparaison.

En effet, dans une mémoire de type mémoire associative, chaque point mémoire est associé, dans le plan mémoire, à une logique supplémentaire qui assure l'exécution des opérations de sélection dont le principe repose sur un test d'égalité ou de similarité.

Le premier ensemble de transistors (assurant la fonction mémorisation) comporte quatre transistors formant un double inverseur.

Les transistors formant ce double inverseur portent les références TR3, TR4, TR7, TR8. Cet ensemble de mémorisation comporte également deux transistors d'accès TR9 et TR10 qui sont reliés par leur grille à une ligne de mots WLI et par leur drain aux lignes de bits BIT et $\overline{BIT}$.

Le deuxième ensemble de transistors est formé par les transistors TRI, TR2, TR5, TR6, formant une porte de type OU EXCLUSIF. Les transistors T1 et T2 sont reliés à l'ensemble de mémorisation par leurs sources (ou les drains) aux sources (ou aux drains) des transistors TR3 et TR4 et par leurs grilles aux grilles des transistors TR3 et TR4 et TR7 et TR8.

La source (ou le drain) des transistors TR5 et TR6 est reliée à une ligne de sélection S. Les grilles des transistors TR5 et TR6 sont reliées aux lignes de bits BIT et $\overline{BIT}$.

Les points P1 et P2 sont les points de mémorisation de la donnée écrite dans le point mémoire. Une opération de lecture se déroule de la façon suivante :

On suppose pour l'explication qu'une donnée a été enregistrée et qu'elle correspond à l'état 1. Ainsi, P1 est à l'état 1 et P2 à l'état 0. On précharge les lignes de bits, BIT et $\overline{BIT}$ à des tensions comprises entre 2,5 v et 5v. On sélectionne la ligne de mots WLI par application d'une tension qui rend conducteurs les transistors TR9 et TR10. Selon l'exemple qui a été pris P1=1 et P2=0, le point P1 ne peut se décharger, alors que la ligne $\overline{BIT}$ va se décharger à travers TR4 et TR10. On retrouve les valeurs de P1 et P2 sur les lignes BIT et $\overline{BIT}$.

Une opération d'écriture se déroule de la façon suivante : on suppose par exemple que P1 est à l'état 1 et P2 à l'état 0 et que l'on veut écrire 0 dans P1 et 1 dans P2.

On va alors rentrer un 0 au moyen de la ligne BIT et un 1 sur la ligne $\overline{BIT}$. On sélectionne ensuite la ligne de mots WLI en appliquant une tension correspondant à un état logique 1 pour la ligne WLI. P1 se décharge et provoque le basculement du point mémoire. Le point P2 passe alors à l'état 1.

Une opération de comparaison se déroule de la manière suivante :

On suppose que le point P1 est égal à 1 et le point P2 est égal à 0. On applique une tension correspondant à l'état 0 sur la ligne WLI.

On va supposer que l'on tombe sur le cas de l'égalité entre la donnée que l'on rentre et la donnée enregistrée.

On précharge la ligne de sélection S, c'est-à-dire qu'elle est positionnée à l'état 1. On applique donc 1 sur la ligne BIT et 0 sur la ligne $\overline{BIT}$. Le transistor TR5 devient passant et le transistor TR1 reste bloqué. La ligne de sélection S ne se décharge pas et reste à 1.

Le transistor TR6 est bloqué et le transistor TR2 est passant. La ligne de sélection S ne peut pas non plus se décharger par ce chemin et reste à 1. Le fait que la ligne de sélection ne change pas d'état permet de conclure alors qu'il y a égalité entre la donnée entrée et la donnée mémorisée.

Si la donnée entrée est différente du point enregistré en P1, le transistor TR5 est bloqué et le transistor TR1 est également bloqué. La ligne de sélection S ne peut pas se décharger par ce chemin. En revanche, le transistor TR6 devient conducteur et le transistor TR2 devient également conducteur. Il y a création d'un chemin de décharge de la ligne S, chemin qui passe par les transistors TR6 et TR2. S se décharge et passe donc à l'état 0. On sait alors que la valeur entrée est différente du point mémorisé.

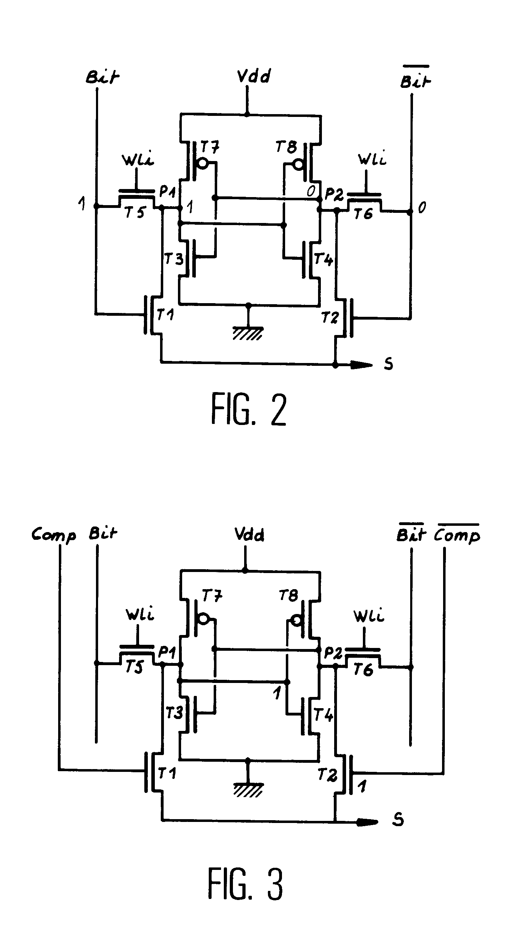

La figure 2 représente un point mémoire statique à huit transistors correspondant à un premier mode de réalisation de l'invention.

Le premier ensemble de transistors assurant la fonction de mémorisation du point est formé des transistors T3, T4, T7 et T8 et également des transistors d'accès T5 et T6. Ces transistors d'accès sont reliés d'une part à la ligne de mots WLI et d'autre part, aux lignes BIT et $\overline{BIT}$.

Conformément à l'invention, le deuxième ensemble assurant la fonction de comparaison d'une donnée entrée à la donnée mémorisée dans le point mémoire comporte deux transistors T1 et T2 reliés aux transistors d'accès T3, T5, T4 et T6. La fonction de comparaison est assurée par la porte logique OU EXCLUSIF réalisée par ces deux transistors T1 et T2 associés aux transistors T3 et T4 du point de mémorisation. Les transistors T1 et T2 sont reliés à la ligne de sélection S par leur drain (ou source) et aux lignes de bits par leur grille.

Selon ce mode de réalisation, les opérations de lecture et d'écriture nécessitent que la ligne de sélection S soit préchargée (S=1). Ainsi l'on évite que les transistors de la logique de comparaison T1 et T2 ne forment un chemin de décharge de la cellule de mémorisation aux points P1 et P2 et de ce fait, l'on évite de compromettre la stabilité du point mémoire.

Le mode de fonctionnement du point mémoire conforme à ce premier mode de réalisation va être décrit dans la suite.

Une opération de lecture comporte les étapes suivantes :

On précharge la ligne de sélection S à 1. On précharge les lignes BIT et $\overline{BIT}$ (BIT=1 et $\overline{BIT}$=1), on positionne la ligne de mots WLI à 1. On suppose que P1=1 et P2=0. La ligne $\overline{BIT}$ va se décharger à travers T4 et T6 et on retrouve les valeurs P1 et P2 sur les lignes BIT et $\overline{BIT}$.

Une opération d'écriture comporte les étapes suivantes :

On veut par exemple écrire 0 au point P1 et 1 au point 2.

On applique alors un 0 sur la ligne BIT et un 1 sur la ligne $\overline{BIT}$. On positionne la ligne WLI à 1. Les transistors T5 et T6 sont conducteurs. Le point P1 se décharge dans la ligne BIT à travers T5, P2 est forcé à 1 par le basculement du point mémoire.

Une opération de comparaison comporte les étapes suivantes :

On précharge la ligne de sélection S, S égale à 1.

On suppose pour l'explication que la donnée que l'on entre est par exemple égale à 0, c'est-à-dire différente de la donnée enregistrée qui se trouve au point P1.

Un 0 est donc appliqué sur la ligne de bits et un 1 sur la ligne $\overline{BIT}$. La ligne de mots WLI est à l'état 0. Ainsi le transistor T1 est bloqué et le transistor T3 est bloqué. Le transistor T2 est conducteur et le transistor T4 reçoit la valeur du point P1 et devient conducteur. Ainsi un chemin de décharge pour la ligne S est créé, ce chemin de décharge passe par les transistors T2 et T4. S se décharge et passe à l'état 0, état qui est différent de la valeur du point P1.

On peut conclure ainsi que la donnée entrée est différente de la donnée enregistrée car l'état de la ligne S est modifié.

On va voir maintenant que lorsque la donnée entrée correspond à la donnée enregistrée au point P1, l'état de la ligne S ne change pas.

En effet, la ligne BIT est égale à 1, la ligne $\overline{BIT}$ est égale à 0, P1 est égal à 1 et P2 est égal à 0. Le transistor T1 est donc passant, le transistor T3 est bloqué (l'état 0 de P2 est appliqué sur sa grille). Le transistor T2 est bloqué, T4 est passant (sa grille est à l'état 1 provenant du point P1). Il n'y a donc pas de chemin de décharge pour la ligne S.

On voit donc que cette structure correspond à un point mémoire associatif statique présentant l'avantage d'avoir un encombrement moindre que celui de l'état de la technique.

On a représenté sur la figure 3 un deuxième mode de réalisation d'un point mémoire conforme à l'invention. Selon ce mode de réalisation, les transistors T1 et T2 de l'ensemble logique de comparaison ont leur grille reliée à deux autres lignes de bits référencées COMP, $\overline{COMP}$. Ces lignes de bits permettent d'entrer la donnée à comparer à la donnée enregistrée, dans le point mémoire P1.

Ainsi, selon ce mode de réalisation, on n'a pas besoin de réaliser une précharge de la ligne de sélection S pendant les opérations de lecture-écriture, comme c'est le cas par exemple pour le mode de réalisation qui vient d'être décrit, relatif au schéma de la figure 2.

Selon ce mode de réalisation, une opération de lecture se réalise de la manière suivante :

Les lignes BIT et $\overline{BIT}$ sont positionnées à 1. On suppose par exemple que le point P1 est à 1 et le point P2 à 0. On sélectionne la ligne de mots WLI en la positionnant à l'état 1. La ligne $\overline{BIT}$ se décharge à travers les transistors T6 et T4. Ainsi on retrouve la valeur du point P1 sur la ligne BIT et la valeur du point P2 sur la ligne $\overline{BIT}$.

Une opération d'écriture se déroule de la manière suivante :

Dans le cas où l'on désire écrire un 0 au point P1 et donc un 1 au point P2, on positionne la ligne BIT à 0 et la ligne $\overline{BIT}$ à 1. On sélectionne la ligne de mots WLI en la positionnant à l'état 1. Le point P1 se décharge à travers T5 et se retrouve donc à l'état 0, tandis que le point P2 est forcé à la valeur 1 par le basculement du point mémoire. Ainsi on retrouve les valeurs entrées par lignes BIT et $\overline{BIT}$ dans les points P1 et P2.

Une opération de comparaison se déroule de la manière suivante :

On précharge la ligne de sélection S en la positionnant à 1. On positionne la ligne de mots à l'état 0. Puis l'on suppose que l'on entre la donnée 0 pour la comparer à la valeur du point enregistrée. On positionne par conséquent la ligne COMP à 0 et la ligne $\overline{COMP}$ à 1. Le transistor T1 est donc bloqué, le transistor T3 est également bloqué. Le transistor T2 est conducteur et le transistor T4 est également conducteur. On crée ainsi un chemin de décharge de la ligne S à travers les transistors T2 et T4. La ligne S qui avait été préchargée à l'état 1 change d'état pour passer à l'état 0. On peut conclure alors que la donnée entrée est différente de la donnée enregistrée. Dans le cas contraire, il n'y aura pas de changement d'état de la ligne S et on conclura que la donnée entrée est égale à la donnée enregistrée.

La structure qui vient d'être décrite permet d'éviter d'avoir à précharger la ligne de sélection lors des opérations de lecture-écriture car elle permet d'isoler la logique de comparaison du point mémoire. Cette structure du point mémoire peut être réalisée avec les technologies actuelles et de préférence avec une technologie à trois niveaux de métaux.

Ainsi pour les deux architectures de point mémoire proposées, l'opération de sélection, c'est-à-dire de comparaison se déroule selon les étapes suivante :
- précharger les lignes de sélection S,
- positionner sur les lignes de bits (les lignes COMP pour la deuxième architecture) la donnée à comparer, ainsi que son complémentaire,
- effectuer la comparaison au moyen de la structure OU EXCLUSIF, formée par les transistors T1, T2, T3, T4.

Si l'égalité est vérifiée, les lignes de sélection restent préchargées. Dans le cas contraire, elles se déchargent à travers l'une des branches créées par les transistors T1, T3 ou T2, T4.

Les deux structures qui viennent d'être décrites permettent donc d'avoir un encombrement moindre et par conséquent pour une surface de mémoire donnée d'augmenter sa densité d'intégration et sa capacité. Elles permettent comme on l'a vu à travers la description de garantir une lecture non destructrice du contenu.

**Revendications**

1. Point mémoire pour mémoire associative statique comprenant deux ensembles de transistors, un premier ensemble ayant une fonction de mémorisation des données et un deuxième ensemble ayant une fonction de comparaison entre la donnée mémorisée et une donnée que l'on applique à l'entrée du point, le résultat de comparaison étant obtenu sur une ligne de sélection S, caractérisé en ce que le deuxième ensemble (T1, T2, T3, T4) de transistors est formé en partie par des transistors du premier ensemble (T3, T4, T7, T8, T5, T6).

2. Point mémoire pour mémoire associative statique selon la revendication 1, caractérisé en ce que le premier ensemble comporte d'une part quatre transistors (T3, T4, T7, T8) pour la mémorisation, et d'autre part, deux transistors d'accès (T5, T6) reliés aux lignes de bits et à une ligne de mots et en ce que le deuxième ensemble comporte deux transistors, les deux transistors T3 et T4 étant associés à ces deux transistors du deuxième ensemble pour assurer la fonction comparaison, la donnée à comparer étant appliquée aux lignes de bits reliées aux deux transistors d'accès du point et la ligne de sélection S étant préchargée lors des lectures-écritures et des comparaisons.

3. Point mémoire pour mémoire associative selon la revendication 1, caractérisé en ce que le premier ensemble comporte d'une part quatre transistors (T3, T4, T7, T8) pour la mémorisation, et d'autre part, deux transistors (T5, T6) d'accès reliés aux lignes de bits et à une ligne de mots et en ce que le deuxième ensemble comporte deux transistors, les deux transistors T3 et T4 étant associés aux deux transistors du deuxième ensemble pour assurer la fonction comparaison, la donnée à comparer étant appliquée à des lignes de bits COMP et $\overline{COMP}$ reliées aux deux transistors du deuxième ensemble.

4. Point mémoire selon l'une quelconque des revendications précédentes, caractérisé en ce qu'il est réalisé en technologie CMOS.

5. Mémoire associative statique caractérisé en ce qu'elle comprend un plan mémoire constitué d'une matrice de points mémoire selon l'une quelconque des revendications précédentes.

FIG. 1

FIG. 2

FIG. 3

EP 0 550 347 A1

**Office européen des brevets**

# RAPPORT DE RECHERCHE EUROPEENNE

Numero de la demande

EP 92 40 3587

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-3 936 811 (HORNINGER) <br> * abrégé * <br> * colonne 2, ligne 50 - colonne 8, ligne 54; figures 1-3 * <br> --- | 1-5 | G11C15/00 |
| A | FR-A-2 549 998 (EFCIS) <br> * abrégé * <br> * page 2, ligne 35 - page 6, ligne 31; figure 2 * <br> --- | 1-5 | |
| A | US-A-4 965 767 (KINOSHITA ET AL.) <br> * abrégé * <br> * colonne 1, ligne 11 - colonne 2, ligne 21; figure 8 * <br><br> ----- | 1-5 | |
| | | | **DOMAINES TECHNIQUES RECHERCHES (Int. Cl.5)** <br><br> G11C |

Le présent rapport a été établi pour toutes les revendications

| Lieu de la recherche | Date d'achèvement de la recherche | Examinateur |
|---|---|---|
| LA HAYE | 09 MARS 1993 | STECCHINA A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..............................................................................................
& : membre de la même famille, document correspondant

EPO FORM 1503 03.82 (P0402)